# EUROPÄISCHE PATENTSCHRIFT

(11) **EP 2 422 592 B1**
(45) Veröffentlichungstag und Bekanntmachung des Hinweises auf die Patenterteilung: **29.05.2013**
(21) Anmeldenummer: 10717477.3
(22) Anmeldetag: 14.04.2010
(51) Int. Cl.: H05K 3/00, H05K 3/34, H05K 13/00

(54) **VERFAHREN ZUM VORBEHANDELN EINES RAHMEN- BZW. TRÄGERELEMENTS FÜR EINE HERSTELLUNG EINER LEITERPLATTE**
METHOD FOR PRETREATING A FRAME OR CARRIER ELEMENT FOR THE PRODUCTION OF A CIRCUIT BOARD
PROCÉDÉ DE PRÉTRAITEMENT D'UN ÉLÉMENT SERVANT DE CADRE OU DE SUPPORT POUR LA FABRICATION D'UNE CARTE DE CIRCUITS IMPRIMÉS

(30) Priorität: 20.04.2009 AT 24609 U
(43) Veröffentlichungstag der Anmeldung: 29.02.2012
(73) Patentinhaber: AT & S Austria Technologie & Systemtechnik Aktiengesellschaft, 8700 Leoben-Hinterberg (AT)
(72) Erfinder: MARELJIC, Ljubomir, Shanghai (CN); ZHANG, Anderson, Shanghai (CN)
(74) Vertreter: Miksovsky, Alexander
(86) Internationale Anmeldenummer: PCT/AT2010/000103
(87) Internationale Veröffentlichungsnummer: WO 2010/121277

(56) Entgegenhaltungen:
- EP-A1- 0 508 977
- EP-A1- 0 804 990
- EP-A2- 1 980 601
- US-A- 5 785 307
- US-A- 6 152 353
- US-A- 6 164 636
- US-A1- 2005 001 019
- US-A1- 2007 209 828

## Beschreibung

Die vorliegende Erfindung bezieht sich auf Verfahren zum Vorbehandeln eines Rahmen- bzw. Trägerelements zum Einsatz bei der Herstellung einer Leiterplatte, wobei das Rahmen- bzw. Trägerelement nach der Vorbehandlung mit wenigstens einem Leiterplattenelement gekoppelt wird und wenigstens einem Bearbeitungsschritt insbesondere unter erhöhter Temperatur gemeinsam mit dem Leiterplattenelement, insbesondere einer Bestückung des Leiterplattenelements, unterworfen wird, wobei das Rahmen- bzw. Trägerelement einer Wärmebehandlung bei Temperaturen zwischen 120 °C und 350 °C, insbesondere 200 °C bis 300 °C, für einen Zeitraum von 5 bis 300 Sekunden, insbesondere 10 bis 200 Sekunden unterworfen wird. Die vorliegende Erfindung bezieht sich darüber hinaus auf eine Verwendung eines derartigen Rahmen- bzw. Trägerelements.

Im Zusammenhang mit der Herstellung von Leiterplatten ist es bekannt, eine Mehrzahl von Leiterplatten bzw. Leiterplattenelementen als ein gemeinsames, plattenartiges Element herzustellen, wobei derartige Leiterplatten üblicherweise jeweils aus einer Mehrzahl von leitenden und isolierenden Schichten und/oder in einer derartigen Leiterplatte integrierten Bauteilen bestehen. Gemäß derart bekannten Herstellungsverfahren erfolgt ein im wesentlichen vollflächiger Aufbau einer Mehrzahl von Leiterplatten auf dem gemeinsamen plattenartigen Element, worauf nach Fertigstellung der Leiterplatten, diese voneinander getrennt werden. Hiebei weist jede Leiterplatte an ihrem Umfangsrand und somit außerhalb eines ein tatsächliches Leiterplattenelement bildenden, im wesentlichen zentralen Bereichs, in welchem die Strukturen zum Aufbau der Leiterplatte und/oder elektronische Bauteile integriert sind, einen entsprechenden Randbereich auf. Dieser ist vorgesehen, um weitere Bearbeitungsschritte einer derartigen Leiterplatte, wie beispielsweise im Rahmen einer Bestückung mit an wenigstens einer Oberfläche festzulegenden Komponenten und/oder eines Einbaus in eine elektrische oder elektronische Vorrichtung durchzuführen, um eine Handhabung und insbesondere ein automatisches Ergreifen einer derartigen Leiterplatte im Rahmen nachfolgender Be- bzw. Verarbeitungsschritte zu ermöglichen. Gemäß derzeit bekannten Verfahrensführungen ist somit davon auszugehen, dass der für den Rahmen bzw. Randbereich der Leiterplatte zur Verfügung zu stellende Umfangsbereich ebenfalls aus üblicherweise kostspieligem Material entsprechend der üblicherweise mehrlagigen Leiterplatte hergestellt wird. Ein derartiger Rand- bzw. Umfangsbereich, welcher für die Funktion der Leiterplatte im Hinblick auf einen üblicherweise mehrlagigen Aufbau aus kostspieligen Materialien nicht erforderlich ist, führt jedoch zu erhöhten Kosten einer derartigen Leiterplatte. Darüber hinaus ist davon auszugehen, dass im Rahmen von bekannten Herstellungsverfahren von Leiterplatten zwischen einzelnen Leiterplattenelementen liegende Bereiche bzw. Flächen des gemeinsamen plattenartigen Elements als Abfall verworfen werden, so dass auch in diesem Zusammenhang erhöhte Kosten für die Herstellung der Leiterplatten bzw. Leiterplattenelemente auflaufen.

Darüber hinaus ist es im Zusammenhang mit der Herstellung von Leiterplatten beispielsweise bekannt, einzelne schadhafte Leiterplatten auf einem gemeinsamen plattenartigen Element zu entfernen, falls diese im Verlauf von Tests bzw. Überprüfungen als schadhaft erkannt wurden, und anstelle von derartigen entfernten schadhaften Leiterplatten einzelne Leiterplatten einzusetzen, um in nachfolgenden Be- bzw. Verarbeitungsschritten, insbesondere einer Bestückung eine maximale Anzahl von Leiterplattenelementen in gemeinsamen Bearbeitungsschritten bearbeiten zu können.

Darüber hinaus sind Verfahren zum gemeinsamen Bearbeiten und Handhaben von Leiterplatten bekannt, wonach in die Leiterplatten jeweils am gesamten Umfang umgebende Rahmenelemente üblicherweise mehrere Leiterplatten bzw. Leiterplattenelemente eingesetzt und daran beispielsweise durch ein Verkleben festgelegt werden. Hiebei kann beispielsweise auf die DE-A 196 00 928, die US-PS 4,689,103 oder die US-PS 5,044,615 verwiesen werden. Nachteilig bei diesen bekannten Verfahren zum Einsetzen von Leiterplatten in ein die Leiterplatten wenigstens teilweise und insbesondere jeweils vollständig umgebendes Rahmenelement ist insbesondere die Tatsache, dass die für die Anordnung der Leiterplatten in dem Rahmenelement vorzusehenden Aufnahmeöffnungen exakt an die Abmessungen der einzusetzenden Leiterplatten angepasst werden müssen und dadurch eine ordnungsgemäße Festlegung beispielsweise mit Hilfe einer Verklebung an den Umfangsrändern der üblicherweise eine vergleichsweise geringe Dicke aufweisenden Leiterplatten und Rahmenelemente äußerst schwierig und aufwendig ist.

Aus der EP 0 508 977 A1, der US 5 785 307 A sowie der US 6 152 353 A sind unterschiedliche Ausführungsformen von jeweils mit einem Rahmen- bzw. Trägerelement verbundenen Leiterplatten bzw. Leiterplattenelementen zu entnehmen, welche wenigstens einem Bearbeitungsschritt insbesondere unter erhöhter Temperatur gemeinsam mit dem Leiterplattenelement unterworfen werden. Die Rahmen- bzw. Trägerelemente können hierbei üblicherweise mehrmals mit Leiterplatten verbunden und derartigen Bearbeitungsschritten unterworfen werden. Derartige Bearbeitungsschritte von Leiterplatten unter erhöhter Temperatur werden beispielsweise bei den eingangs genannten Temperaturen durchgeführt, wie dies unter anderem der US 6 164 636 A, der EP 1 980 601 A2 oder der US 2005/001019 A1 zu entnehmen ist.

Bei einer Kopplung zwischen jeweils wenigstens einem Leiterplattenelement und einem Rahmen- bzw. Trägerelement kann insbesondere in Abhängigkeit von nachfolgenden Be- bzw. Verarbeitungsschritten vorgesehen sein, dass eine lösbare Kopplung zwischen dem Rahmen- bzw. Trägerelement und dem Leiterplattenelement vorliegt, so dass nach weiteren Bearbeitungsschritten, beispielsweise einer Bestückung, das Rahmen- bzw. Trägerelement wiederum von dem Leiterplattenelement entfernt wird, und ein derart von dem Rahmen- bzw. Trägerelement befreites Leiterplattenelement in ein elektronisches Gerät eingesetzt wird.

Daneben ist es auch möglich, eine permanente Verbindung bzw. Kopplung zwischen einem Rahmen- bzw. Trägerelement und einem Leiterplattenelement auch nach erforderlichen Bearbeitungsvorgängen, wie beispielsweise einer Bestückung, beispielsweise durch ein Verkleben vorzusehen, so dass eine Kombination aus einem Rahmen- bzw. Trägerelement und einem Leiterplattenelement in weiterer Folge beispielsweise in Gerät eingebaut wird. Bei Bereitstellung von größeren Rahmen- bzw. Trägerelementen, welche zur Aufnahme einer Mehrzahl von Leiterplattenelementen dienen, kann hierbei eine Trennung in einzelne Leiterplattenelemente durch eine entsprechende Trennung bzw. Zerteilung des Rahmen- bzw. Trägerelements, welches eine Vielzahl von Leiterplattenelementen aufgenommen hat, in einzelne Untereinheiten erfolgen, welche lediglich aus einem Teilbereich des Rahmen- bzw. Trägerelements und jeweils einem Leiterplattenelement für eine weitere Verwendung bestehen.

Darüber hinaus ist es für derartige letztgenannte Verfahren, worin Rahmen- bzw. Trägerelemente mit jeweils einer Mehrzahl von in nachfolgenden Bearbeitungsschritten, insbesondere Bestückungsschritten zu bearbeitenden Leiterplattenelementen verbunden werden, bekannt, dass insbesondere unter Berücksichtigung der während nachfolgender Bearbeitungsschritte auftretenden erhöhten Temperaturen, beispielsweise im Zusammenhang mit Lötprozessen, ein Schrumpfen bzw. allgemein eine Änderung von Abmessungen sowohl der Leiterplattenelemente als auch der diese wenigstens teilweise umgebenden Rahmen- bzw. Trägerelemente auftritt. Es wird hierbei davon ausgegangen, dass derartige Änderungen der Größe insbesondere aus einer Verdampfung bzw. einem Austreten von in den Materialien aufgenommener Feuchtigkeit während derartiger Be- bzw. Verarbeitungsschritte unter erhöhter Temperatur resultieren. Dadurch kommt es nicht nur zu Größenänderungen und gegebenenfalls Verformungen sowohl der Leiterplattenelemente als auch der damit verbundenen Rahmen- bzw. Trägerelemente. Es ist darüber hinaus zu berücksichtigen, dass trotz der Tatsache, dass derartige Rahmen- bzw. Trägerelemente aus in der Herstellung von Leiterplatten üblichen Materialien ausgebildet sind, die Leiterplattenelemente als auch die Rahmen- bzw. Trägerelemente üblicherweise unterschiedliche Materialeigenschaften und somit unterschiedliche Größenänderungen während einer Bearbeitung unter erhöhter Temperatur zeigen. Diese unterschiedlichen Materialeigenschaften resultieren beispielsweise insbesondere daraus, dass Leiterplattenelemente wenigstens eine eingebettete Schicht bzw. Lage aus einem entsprechenden dimensionsstabileren metallischen Material, insbesondere Kupfer, und üblicherweise eine Vielzahl von derartigen eingebetteten metallischen Schichten aufweisen, während ein kostengünstiges Rahmen- bzw. Trägermaterial, wie dies oben ausgeführt wurde, derartige zusätzliche metallische Schichten nicht und nur in einer stark verringerten Anzahl von beispielsweise maximal zwei Schichten enthält. Eine derartige stark verringerte Anzahl von metallischen Schichten kann beispielsweise zur Bereitstellung von Markierungs- bzw. Registrierungselementen dienen. Für die Herstellung von Leiterplatten verwendete isolierende Materialien weisen üblicherweise unter erhöhter Temperatur eine erhöhte Größenänderung und somit verringerte Dimensions- bzw. Abmessungsstabilität auf.

Die vorliegende Erfindung zielt daher darauf ab, ein Verfahren der eingangs genannten Art zum Einsatz bei der Herstellung einer Leiterplatte zur Verfügung zu stellen, wobei die oben genannten Nachteile bzw. Probleme des Standes der Technik insbesondere im Hinblick auf einen Einsatz bei weiteren Be- bzw. Verarbeitungsschritten insbesondere unter erhöhter Temperatur vermieden oder zumindest minimiert werden können, und insbesondere ein Rahmen- bzw. Trägerelement mit für einen Einsatz während nachfolgender Be- bzw. Verarbeitungsschritte bei der Herstellung von Leiterplatten erhöhter Abmessungs- bzw. Dimensionsstabilität zur Verfügung zu stellen.

Zur Lösung dieser Aufgaben ist das erfindungsgemäße Verfahren der eingangs genannten Art im wesentlichen dadurch gekennzeichnet, dass das Rahmen- bzw. Trägerelement unmittelbar nach der Wärmebehandlung mit wenigstens einem Leiterplattenelement verbunden bzw. gekoppelt und einer Bearbeitung des Leiterplattenelements unterworfen wird oder dass das Rahmen- bzw. Trägerelement nach der Wärmebehandlung vor einer Kopplung mit einem Leiterplattenelement unter Feuchtigkeitsausschluss und luftdicht verpackt wird und gelagert wird. Da das Rahmen- bzw. Trägerelement einer Wärmebehandlung bzw. Vorbehandlung unter erhöhter Temperatur für einen vorgegebenen Zeitpunkt unterworfen wird, wird sichergestellt, dass gegebenenfalls zu einem Schrumpfen bzw. allgemein zu einer Änderung der Abmessungen des Rahmen- bzw. Trägerelements führende Materialien aus dem Rahmen- bzw. Trägerelement entfernt werden, so dass für nachfolgende Be- bzw. Verarbeitungsschritte nach einer insbesondere lösbaren Kopplung mit üblicherweise einer Vielzahl von Leiterplattenelementen ein entsprechend dimensions- und formstabiles Rahmen- bzw. Trägerelement zur Verfügung gestellt werden kann. Dadurch, dass durch das erfindungsgemäße Verfahren ein entsprechendes form- bzw. dimensionsstabiles Rahmen- bzw. Trägerelement zur Verfügung gestellt werden kann, wird während nachfolgender Be- bzw. Verarbeitungsschritte und insbesondere unter erhöhter Temperatur sichergestellt, dass insbesondere unter Berücksichtigung der gegebenenfalls unterschiedlichen Materialeigenschaften bei einem Aussetzen an erhöhter Temperatur zwischen den Leiterplattenelementen und dem bzw. den damit verbundenen Rahmen- bzw. Trägerelement(en) ein Verwerfen bzw. Verwinden der miteinander verbundenen Elemente während nachfolgender Bearbeitungsschritte vermieden wird. Zur Vermeidung von Langzeiteffekten im Hinblick auf eine gegebenenfalls mögliche Aufnahme insbesondere von Feuchtigkeit in das wärmebehandelte Rahmen- bzw. Trägerelement, welches der erfindungsgemäßen Wärmebehandlung unterworfen wurde, wird erfindungsgemäß vorgeschlagen, dass das Rahmen- bzw. Trägerelement unmittelbar nach der Wärmebehandlung mit wenigstens einem Leiterplattenelement verbunden bzw. gekoppelt und einer Bearbeitung des Leiterplattenelements unterworfen wird. Durch eine derartige erfindungsgemäß vorgeschlagene Verbindung bzw. Kopplung mit dem wenigstens einen Leiterplattenelement im wesentlichen unmittelbar nach der Wärmebehandlung wird sichergestellt, dass die durch die Wärmebehandlung erzielte Form- bzw. Abmessungsstabilität des Rahmen- bzw. Trägerelements während nachfolgender Bearbeitungsvorgänge des Leiterplattenelements wiederum insbesondere unter Einsatz erhöhter Temperaturen zuverlässig aufrecht erhalten und beibehalten wird. Sollte eine unmittelbare Kopplung bzw. Verbindung mit wenigstens einem Leiterplattenelement nicht möglich bzw. vorgesehen sein, so wird erfindungsgemäß alternativ vorgeschlagen, dass das Rahmen- bzw. Trägerelement nach der Wärmebehandlung vor einer Kopplung mit einem Leiterplattenelement unter Feuchtigkeitsausschluss und luftdicht verpackt wird und gelagert wird. Derart können Rahmen- bzw. Trägerelemente im wesentlichen unabhängig von dem Ort einer nachfolgenden Verbindung bzw. Kopplung zur Bearbeitung, insbesondere Bestückung von Leiterplattenelementen hergestellt und vorbereitet werden und es kann unter Beibehaltung der durch die erfindungsgemäße Verfahrensführung erzielten verbesserten Form- bzw. Dimensionsstabilität ein Bearbeitungsvorgang, insbesondere Bestückungsvorgang mit jeweils einer Mehrzahl von Leiterplattenelementen zu einem beliebig wählbaren späteren Zeitpunkt zur Verfügung gestellt werden.

Durch Bereitstellen eines derartigen form- bzw. dimensionsstabilen Rahmen- bzw. Trägerelements wird es somit möglich, größere Arrays bzw. Nutzen mit einer erhöhten Anzahl von jeweils in einem gemeinsamen Bearbeitungsschritt zu bearbeitenden Leiterplattenelementen zur Verfügung zu stellen, wobei derartige größere Arrays beispielsweise unter Bereitstellung lediglich einer Markierung die Bestückung bzw. allgemein Bearbeitung einer erhöhten Anzahl von Leiterplattenelementen erlauben.

Es kann somit eine geringe Anzahl von Markierung bzw. Fiducials für das gesamte Array verwendet werden. Aufgrund der Tatsache, dass entsprechend dem erfinderischen Verfahren hergestellte, form- bzw. dimensionsstabile Rahmen- bzw. Trägerelemente eine bedeutend geringere Dimensionsänderung aufweisen, können derartige Rahmen- bzw. Trägerelemente verlängert bzw. vergrößert werden, wobei unverändert die im Rahmen von nachfolgenden Be- bzw. Verarbeitungsschritten einzuhaltenden Prozesstoleranzen erfüllt werden können.

Bei derzeit bekannten Materialien für Rahmen- bzw. Trägerelemente, welche eine entsprechend größere Dimensionsänderung aufweisen, wie dies oben erwähnt ist, wird hingegen versucht, das Problem der großen Dimensionsänderungen zur Einhaltung von Prozesstoleranzen dadurch zu umgehen, dass Markierungen auf jedem zu bearbeitenden Leiterplattenelement vorgesehen sind, wobei derartige zusätzliche Markierungen entsprechend den Durchsatz von bekannten nachfolgenden Verfahren reduzieren. Das erfindungsgemäß bereitgestellte form- bzw. dimensionsstabile Rahmen- bzw. Trägerelement, bei welchem mit einer geringen Anzahl von Registrierungen für eine Vielzahl von gleichzeitig zu behandelnden Leiterplattenelementen das Auslangen gefunden werden kann, ermöglicht somit einen erhöhten Durchsatz.

Durch Bereitstellung eines derartigen form- bzw. dimensionsstabilen Rahmen- bzw. Trägerelements wird es darüber hinaus möglich, den Abstand zwischen einzelnen Leiterplattenelementen zu erhöhen, so dass Bearbeitungs- bzw. Bestückungsschritte, welche derzeit nur getrennt für einzelne Leiterplattenelemente aufgrund des geringen Abstands zwischen einzelnen Leiterplattenelementen durchgeführt werden können, durch Einsatz einer erfindungsgemäß behandelten form- bzw. dimensionsstabilen Rahmen- bzw. Trägerelements in einem Bearbeitungsvorgang bzw. Bestückungsvorgang an einem Array gleichzeitig für eine Mehrzahl von Leiterplattenelementen vorgenommen werden können.

Darüber hinaus werden zunehmend Leiterplattenelemente von beiden Oberflächen bzw. Seiten mit elektronischen Bauteilen oder ähnlichen Elementen bestückt. Eine derartige Bearbeitung sieht üblicherweise die Bestückung der entsprechenden Vielzahl von Leiterplattenelementen von einer Seite bzw. Oberfläche mit einer nachfolgenden Bearbeitung bzw. Behandlung unter erhöhter Temperatur, beispielsweise einem Reflow-Lötprozess vor. Nach einer derartigen Bestückung einer Seite wird das Array, bestehend aus der Vielzahl von Leiterplattenelementen und wenigstens einem Rahmen- bzw. Trägerelement gewendet und es erfolgt eine Bestückung der anderen Seite bzw. Oberfläche der Vielzahl von Leiterplattenelementen, welche wiederum von einer Bearbeitung unter erhöhter Temperatur, insbesondere einem Reflow-Lötprozess gefolgt wird. Durch die Bereitstellung eines durch das erfindungsgemäße Verfahren form- bzw. dimensionsstabilen Rahmen- bzw. Trägerelements wird sichergestellt, dass trotz mehrfacher Wärmebehandlung als auch bei einem Bestücken von beiden Seiten vorzunehmender Wendeprozesse die gegenseitige Lage der einzelnen zu bestückenden Leiterplattenelemente in den für die Herstellung von Leiterplattenelementen vorgegebenen geringen Toleranzbereichen aufrecht erhalten wird. Derartige Toleranzbereiche liegen beispielsweise in einer Größenordnung von ± 25 - 30 µm bis etwa 50 µm auf eine Länge von 270 mm bis 400 mm, so dass die Genauigkeit bei der Herstellung einer Vielzahl von Leiterplattenelementen durch das erfindungsgemäß hergestellte Rahmen- bzw. Trägerelement verbessert werden kann. Eine derartige verbesserte Genauigkeit und Dimensionsstabilität verringert somit einen potentiellen Ausschuss bei der Herstellung von Leiterplattenelementen, wodurch sich eine entsprechend verbesserte Produktivität bzw. geringere Kosten für die Herstellung von Leiterplattenelementen erzielen lässt (lassen). Eine weitere Steigerung der Produktivität bei somit verringerten Kosten für die Herstellung einzelner Leiterplattenelemente lässt sich auch durch die oben angeführte Möglichkeit einer gleichzeitigen Be- bzw. Verarbeitung einer erhöhten Anzahl von Leiterplattenelementen erzielen.

Zur Erzielung bzw. Beibehaltung der verbesserten Form- bzw. Dimensionsstabilität des Rahmen- bzw. Trägerelements insbesondere während der Leiterplattenherstellung während bei Lötprozessen auftretenden hohen Temperaturen wird gemäß einer bevorzugten Ausführungsform vorgeschlagen, dass das Rahmen- bzw. Trägerelement einer Wärmebehandlung bei einer Temperatur von wenigstens 210 °C für einen Zeitraum von 40 bis 100 Sekunden, insbesondere wenigstens 60 Sekunden unterworfen wird. Eine derartige Wärmebehandlung bei einer Temperatur über 210 °C für den vorgeschlagenen bzw. vorgegebenen Zeitraum stellt sicher, dass Abmessungs- bzw. Dimensionsänderungen des Rahmen- bzw. Trägerelements bei in nachfolgenden Schritten auftretenden erhöhten Temperaturen, wie sie beispielsweise bei Lötprozessen auftreten bzw. erforderlich sind, minimiert bzw. vermieden werden können.

Zur weiteren Verbesserung der Form- bzw. Abmessungsstabilität des Rahmen- bzw. Trägerelements bei hohen Temperaturen wird gemäß einer weiters bevorzugten Ausführungsform vorgeschlagen, dass das Rahmen- bzw. Trägerelement einer Wärmebehandlung bei einer Temperatur von wenigstens 250 °C für einen Zeitraum von wenigstens 10 Sekunden unterworfen wird.

Während, wie oben angeführt, zur Erzielung einer entsprechend verbesserten Form- bzw. Abmessungsstabilität bei erhöhten Temperaturen eine Behandlung des Rahmen- bzw. Trägerelements bei entsprechend hohen Temperaturen erforderlich und zielführend ist, ist davon auszugehen, dass insbesondere bei eine größere Dicke aufweisenden Rahmen- bzw. Trägerelementen ein Entfernen von Form- bzw. Dimensionsänderungen bewirkenden Materialien aus dem Inneren des Rahmen- bzw. Trägerelements einen entsprechend erhöhten Zeitraum in Anspruch nimmt. Für eine derartige Wärmebehandlung auch innen liegender bzw. tiefer liegender Bereiche und eine Vorbereitung des Rahmen- bzw. Trägerelements für eine nachfolgende Behandlung bei erhöhten Temperaturen, wie sie oben angeführt sind, wird gemäß einer weiters bevorzugten Ausführungsform des erfindungsgemäßen Verfahrens vorgeschlagen, dass das Rahmen- bzw. Trägerelement einer Wärmebehandlung bei einer Temperatur von wenigstens 140 °C, insbesondere zwischen 150 °C und 180 °C, für einen Zeitraum von wenigstens 100 Sekunden, insbesondere 120 bis 180 Sekunden vor einem weiteren Erwärmen auf wenigstens 210 °C unterworfen wird.

Zur Beibehaltung der Struktur bzw. des Aufbaus des wärmebehandelten Rahmen- bzw. Trägerelements nach einem Aussetzen an eine maximale bzw. Peaktemperatur wird gemäß einer weiters bevorzugten Ausführungsform vorgeschlagen, dass das Rahmen- bzw. Trägerelement nach einer Wärmebehandlung bei einer maximalen Temperatur mit einer Abkühlgeschwindigkeit von 3 °C/s bis 7 °C/s, insbesondere maximal 5 °C/s abgekühlt wird. Durch Einhaltung derartiger gesteuerter bzw. geregelter und insbesondere vergleichsweise hoher Abkühlraten bzw. -geschwindigkeiten wird verhindert, dass beispielsweise aus der Umgebung wiederum insbesondere Feuchtigkeit in das wärmebehandelte Rahmen- bzw. Trägermaterial eintritt und die erwünschte und durch die Wärmebehandlung erzielte Form- bzw. Abmessungsstabilität wieder verschlechtert wird.

Zur weiteren Verbesserung der Form- bzw. Dimensionsstabilität des zu behandelnden Rahmen- bzw. Trägerelements wird gemäß einer weiters bevorzugten Ausführungsform vorgeschlagen, dass das Rahmen- bzw. Trägerelement einer mehrfachen Wärmebehandlung mit dazwischen liegender Abkühlung unterworfen wird. Eine derartige mehrfache Wärmebehandlung unter Einhaltung der oben genannten Parameter im Hinblick auf Temperatur und Behandlungsdauer stellt sicher, dass insbesondere nach einer vergleichsweise geringen Anzahl von Wärmebehandlungsvorgängen eine Form- bzw. Dimensionsstabilität des zu behandelnden Rahmen- bzw. Trägerelements erzielbar ist, welche bei weiterführenden Wärmebehandlungen keinerlei Änderungen der Form bzw. Abmessungen des Rahmen- bzw. Trägerelements ergibt. Hiebei hat sich gezeigt, dass mit einer vergleichsweisen geringen Anzahl von Wärmebehandlungen eine gleichbleibende Form- bzw. Dimensionsstabilität erzielbar ist, wobei diese bei üblichen, in der Herstellung von Leiterplatten eingesetzten Materialien, beispielsweise nach zwei bis drei Wärmebehandlungsvorgängen erzielbar ist.

Während Rahmen- bzw. Trägerelemente teilweise aus speziell vorbereiteten Ausgangsmaterialien unmittelbar der erfindungsgemäß vorgeschlagenen Wärmebehandlung zur Erzielung der verbesserten Dimensionsstabilität unterworfen werden können, ist es in vielen Fällen erforderlich, ausgehend von für Rahmen- bzw. Trägerelemente üblicherweise eingesetzten Materialien, wie diese nachfolgend im Detail erörtert werden, diese insbesondere in Abstimmung mit den in weiterer Folge zu koppelnden Leiterplattenelementen vorzubereiten bzw. herzustellen. Hiefür wird vorgeschlagen, dass das Rahmen- bzw. Trägerelement vor der Wärmebehandlung einem Verpressen und Aushärten unterworfen wird und/oder aus mehreren Lagen eines Ausgangsmaterials aufgebaut wird, wie dies einer weiters bevorzugten Ausführungsform des erfindungsgemäßen Verfahrens entspricht. Derart kann zur Erzielung der gewünschten Form- bzw. Dimensionsstabilität ein einer Wärmebehandlung zu unterziehendes Rahmen- bzw. Trägerelement in einem vorbereiteten Verfahrens- bzw. Prozessschritt einem Verpressen und Aushärten eines Ausgangsmaterials unterworfen werden oder es kann beispielsweise auch für das Rahmen- bzw. Trägerelement ein mehrlagiger Aufbau aus einem Ausgangsmaterial vorgesehen sein.

Da für eine Überprüfung der Form- bzw. Dimensionsstabilität der für die Rahmen- bzw. Trägerelemente eingesetzten Materialien teilweise normierte Standards vorgegeben sind und diese Standards üblicherweise anhand von vollflächigen Materialien und insbesondere Platten mit vorgegebenen und standardisierten Abmessungen definiert sind, wird gemäß einer weiters bevorzugten Ausführungsform des erfindungsgemäßen Verfahrens vorgeschlagen, dass ein vollflächiges bzw. plattenförmiges Basismaterial der Wärmebehandlung unterworfen wird und dass das Rahmen- bzw. Trägerelement nach dem Abkühlen des plattenförmigen Basismaterials aus diesem ausgebildet, insbesondere geschnitten wird. Es wird derart ein im wesentlichen vollflächiges und plattenförmiges Material für das nachfolgend herzustellende und bereitzustellende Rahmen- bzw. Trägerelement zur Verfügung gestellt, welches nach der Wärmebehandlung vor einer Kopplung bzw. Verbindung mit üblicherweise einer Mehrzahl von Leiterplattenelementen in eine gewünschte Form ausgebildet, insbesondere geschnitten wird.

Weitere Verbesserungen im Hinblick auf eine Vermeidung von Langzeiteffekten lassen sich dadurch erzielen, dass das Rahmen- bzw. Trägerelement nach der Wärmebehandlung vor einer Kopplung mit einem Leiterplattenelement vakuumverpackt und gelagert wird, wie dies einer weiters bevorzugten Ausführungsform des erfindungsgemäßen Verfahrens entspricht.

Im Hinblick auf einen möglichst umgehenden Einsatz eines erfindungsgemäßen wärmebehandelten Rahmen- bzw. Trägerelements für Be- bzw. Verarbeitungsschritte im Rahmen der Herstellung einer Leiterplatte oder auf eine Lagerung desselben wird gemäß einer weiters bevorzugten Ausführungsform vorgeschlagen, dass eine Verbindung bzw. Kopplung des Rahmen- bzw. Trägerelements mit einem Leiterplattenelement oder ein Verpacken des Rahmen- bzw. Trägerelements nach einem Zeitraum von höchstens 72 Stunden, insbesondere höchstens 48 Stunden nach der Wärmebehandlung vorgenommen wird.

Wie oben bereits ausgeführt, wird gemäß einer weiters bevorzugten Ausführungsform vorgeschlagen, dass das Rahmen- bzw. Trägerelement in an sich bekannter Weise aus einem für die Herstellung eines Leiterplattenelements geeigneten Material, insbesondere einem mit Epoxidharz getränkten Glasfasermattenmaterial gebildet wird.

Ein derartiges Rahmen- bzw. Trägerelement zum Einsatz zur Herstellung einer Leiterplatte kann nach einer Vorbehandlung entsprechend dem erfindungsgemäßen Verfahren oder einer bevorzugten Ausführungsform davon mit wenigstens einem Leiterplattenelement koppelbar sein und in wenigstens einem Bearbeitungsschritt insbesondere unter erhöhter Temperatur gemeinsam mit dem Leiterplattenelement, insbesondere einer Bestückung des Leiterplattenelements, einsetzbar sein, wobei das Rahmen- bzw. Trägerelement unter erhöhten Temperaturen eine Dimensions- bzw. Abmessungsstabilität von besser als ± 0,02 %, insbesondere besser als 0,01 %, besonders bevorzugt besser als 0,0075 % aufweist. Derart kann ein form- und dimensionsstabiles Rahmen- bzw. Trägerelement zur Verfügung gestellt werden, welches insbesondere in nachfolgenden Be- bzw. Verarbeitungsschritten bei der Herstellung von Leiterplatten nach einer Kopplung bzw. Verbindung mit üblicherweise einer überaus großen Anzahl von Leiterplattenelementen eine entsprechend zuverlässige Herstellung bzw. Bearbeitung einer derartigen Vielzahl von Leiterplattenelementen ermöglicht.

Weiters kann das Rahmen- bzw. Trägerelement in an sich bekannter Weise aus einem für die Herstellung eines Leiterplattenelements geeigneten Material, insbesondere einem mit Epoxidharz getränkten Glasfasermattenmaterial gebildet sein.

Darüber hinaus wird erfindungsgemäß die Verwendung eines entsprechend dem erfindungsgemäßen Verfahren oder einer bevorzugten Ausführungsform davon hergestellten Rahmen- bzw. Trägerelements bei der Herstellung einer Leiterplatte zur Verbindung und Bearbeitung mit wenigstens einem Leiterplattenelement vorgeschlagen. Derart lassen sich bei insbesondere reduzierten Kosten Leiterplattenelemente in zuverlässiger und günstiger Weise herstellen.

Die Erfindung wird nachfolgend anhand von in der beiliegenden Zeichnung schematisch dargestellten Ausführungsbeispielen näher erläutert. In dieser zeigen:
Fig. 1 eine schematische Draufsicht eines vollflächigen bzw. plattenförmigen Basismaterials eines Rahmen- bzw. Trägerelements mit standardisierten Abmessungen, das der erfindungsgemäßen Wärmebehandlung unterworfen wird;
Fig. 2 ein schematisches Zeit-Temperatur-Diagramm einer ersten erfindungsgemäßen Verfahrensführung zur Wärmebehandlung eines Rahmen- bzw. Trägerelements;
Fig. 3 in einer zu Fig. 2 ähnlichen Darstellung ein abgewandeltes Zeit-Temperatur-Diagramm einer erfindungsgemäßen Wärmebehandlung eines Rahmen- bzw. Trägerelements;
Fig. 4 eine schematische Darstellung einer Größenänderung von entsprechend dem erfindungsgemäßen Verfahren behandelten Rahmen- bzw. Trägerelementen, wobei Größen- bzw. Dimensionsänderungen nach einer Mehrzahl von Wärmebehandlungszyklen dargestellt sind;
Fig. 5 ein Diagramm einer Größenänderung von entsprechend dem erfindungsgemäßen Verfahren behandelten Rahmen- bzw. Trägerelementen, wobei Größenänderungen der behandelten Rahmen- bzw. Trägerelemente nach Abschluß der Wärmebehandlung gezeigt sind; und
Fig. 6 eine schematische Draufsicht auf ein erfindungsgemäßes Rahmen- bzw. Trägerelement mit einer Mehrzahl von damit gekoppelten Leiterplattenelementen.

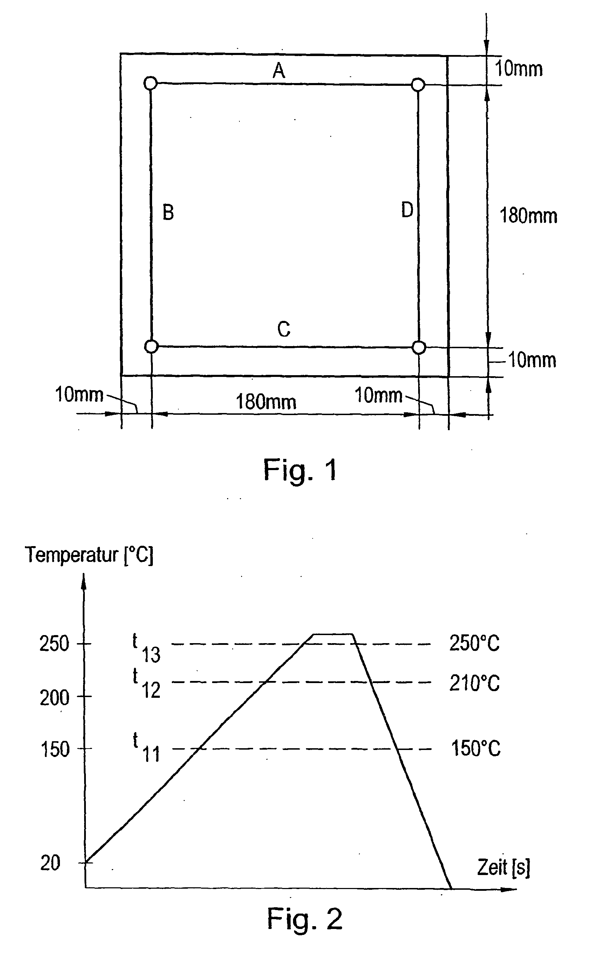

In Fig. 1 ist schematisch eine Draufsicht auf ein vollflächiges bzw. plattenförmiges Basismaterial dargestellt, wobei für eine Feststellung der Form- bzw. Dimensionsstabilität eines derartigen Materials für Rahmen- bzw. Trägerelemente vorgegebene Abmessungen angedeutet sind, wobei relative Änderungen der Abstände zwischen den Löchern und/oder Änderungen der Gesamtabmessungen in den nachfolgenden Diagrammen ausgewertet werden. Anhand derartiger standardisierter Abmessungen der für Rahmen- bzw. Trägerelemente eingesetzten Materialien werden nachfolgend die Verfahrensführungen sowie die erzielbaren Ergebnisse im Detail erörtert.

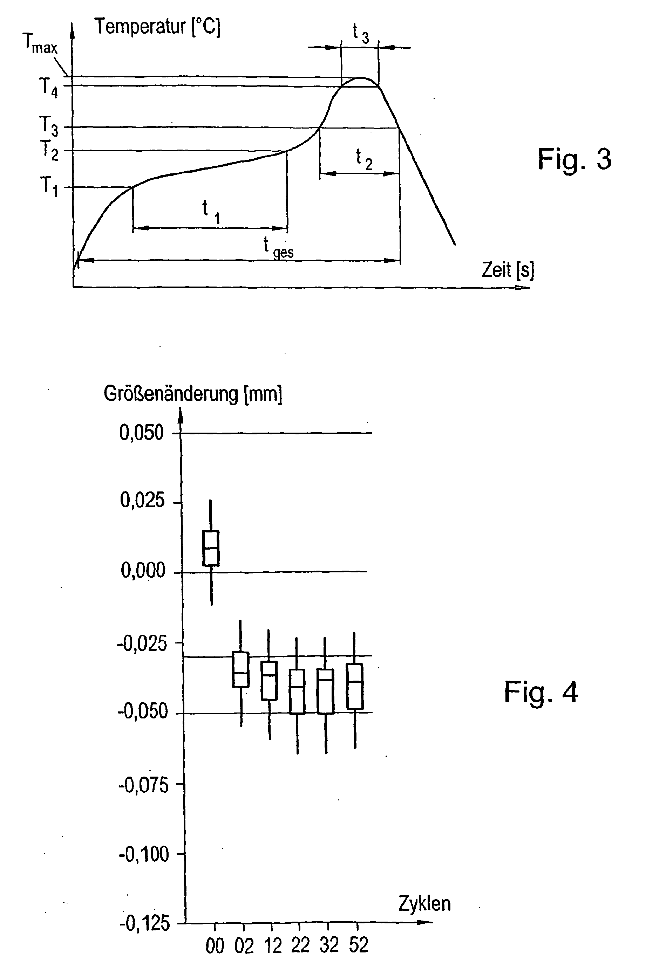

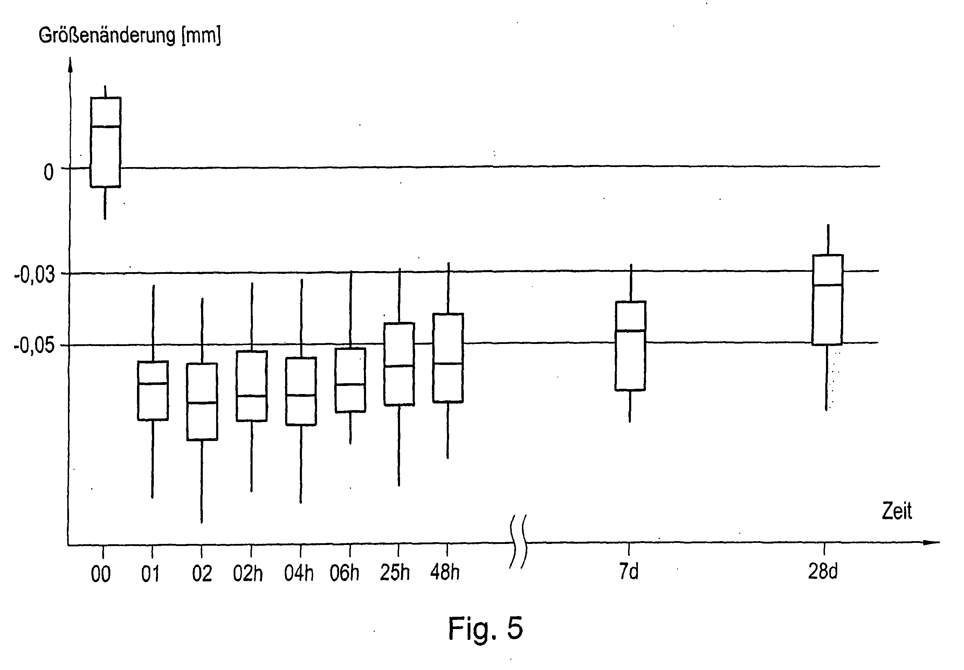

Im Zusammenhang mit den in Fig. 4 und 5 dargestellten Diagrammen wird angemerkt, daß jeweils eine Mehrzahl von Materialproben, wie sie für Rahmen- bzw. Trägerelemente verwendet werden, den nachfolgend im Detail erörterten Wärmebehandlungen unterworfen wurden, wobei üblicherweise jeweils 8 Proben der Behandlung unterworfen wurden und in Fig. 4 und 5 der Mittelwert der erzielten Ergebnisse, insbesondere Größenänderungen, als auch die ermittelten Abweichungen bzw. Standardabweichungen angegeben sind.

Darüber hinaus wurden für die Rahmen- bzw. Trägerelemente in der Herstellung von Leiterplatten übliche Materialien, insbesondere in Epoxidharz getränkte Glasfasermatten bzw. FR-4-Materialien unterschiedlicher Hersteller eingesetzt, wobei bei Materialien unterschiedlicher Hersteller das in Fig. 4 und 5 dargestellte Verhalten jeweils ähnlich war, während gegebenenfalls geringfügige Unterschiede im Hinblick auf absolute Größen- bzw. Dimensionsänderungen insbesondere nach Durchführung einer ersten Wärmebehandlung erkennbar waren.

Die Rahmen- und Trägerelemente können darüber hinaus einer Vorbehandlung, wie beispielsweise einem Verpressen und Aushärten, oder einem Aufbau unter Verwendung mehrere Schichten bzw. Lagen unterworfen werden.

Bei dem in Fig. 2 dargestellten Diagramm, welches nicht maßstabgemäß ist, ist ersichtlich, daß ausgehend von Raumtemperatur ein im wesentlichen gleichmäßiges Erwärmen des Materials des Rahmen- bzw. Trägerelements bis auf eine Temperatur von etwa 260 °C erfolgt, worauf nach einem Halten bei dieser Temperatur über einen Zeitraum von etwa 8-10 Sekunden ein Abkühlen des Materials für das Rahmen- bzw. Trägerelement mit einer gegenüber der Aufheizrate bzw. -geschwindigkeit erhöhten Abkühlgeschwindigkeit bzw. -rate von etwa 6 °C/s bis 7 °C/s erfolgt.

In Fig. 2 angedeutete Zeitdauern eines Aufrechterhaltens der angegebenen Temperaturen von wenigstens 150 °C, wenigstens 210 °C sowie wenigstens 250 °C liegen in folgenden Bereichen:
t₁₁ 100 bis 200 Sekunden
t₁₂ 40 bis 100 Sekunden
t₁₃ wenigstens 10 bis 15 Sekunden.

Gegebenenfalls erfolgt, wie dies insbesondere unter Bezugnahme auf Fig. 4 und 5 im Detail erörtert werden wird, eine mehrfache Wärmebehandlung des Materials des Rahmen- bzw. Trägerelements entsprechend dem in Fig. 2 dargestellten schematischen Zeit-Temperatur-Diagramm.

In Fig. 3 ist ein abgewandeltes Zeit-Temperatur-Diagramm für eine Wärmbehandlung des Materials für die Rahmen- bzw. Trägerelemente dargestellt, wobei in Abwandlung zu dem in Fig. 2 dargestellten Diagramm ersichtlich ist, daß anstelle einer im wesentlichen gleichmäßigen Erwärmung des Materials für die Rahmen- bzw. Trägerelemente unterschiedliche Aufheiz- bzw. Erwärmungsraten insbesondere für den Bereich zwischen etwa 140 °C und 180 °C sowie ein nachfolgendes Aufwärmen auf die maximale Temperatur gewählt werden.

Die im Zeit-Temperatur-Diagramm von Fig. 3 gewählten Parameter sind hiebei wie folgt:
T₁ 150 °C
T₂ 180 °C
T₃ 215 °C
Tₘₐₓ 255 °C
t₁ 120 bis 180 Sekunden
t₂ mindestens 65 Sekunden
t₃ mindestens 10 Sekunden
Gesamtzeit t_{ges} von 40 °C bis 220 °C: mindestens 200 Sekunden.
Abkühlgeschwindigkeit maximal 5 °C/s.

Das in Fig. 3 dargestellte Zeit-Temperatur-Diagramm ist hiebei ähnlich einer üblicherweise bei einer nachfolgenden Herstellung einer Leiterplatte, insbesondere bei Löt- bzw. Reflow-Prozessen eingesetzten Temperaturführung bei einer Bestückung derartiger Leiterplattenelemente.

Aus der Darstellung gemäß Fig. 4 ist ersichtlich, daß ausgehend von einer Ausgangsgröße, welche bei der Zykluszahl "00" angegeben ist, nach einer Durchführung von zwei Wärmebehandlungszyklen, insbesondere gemäß dem Zeit-Temperatur-Diagramm gemäß Fig. 3, eine Größenänderung bzw. Dimensionsänderung der jeweils Mehrzahl von gleichzeitig behandelten Rahmen- bzw. Trägerelementen erzielbar ist, welche sich selbst bei weiteren Zyklen, wenn überhaupt, lediglich im Bereich der Abweichung der untersuchten Materialien für die Rahmen- bzw. Trägerelemente ändert. Hiebei wurden die Abmessungsänderungen auf Basis des in Fig. 1 dargestellten normierten Ausgangsmaterials nach 2, 12, 22, 32 und 52 Wärmebehandlungszyklen gemessen.

Aus Fig. 4 ist ersichtlich, daß bereits nach 2 Wärmebehandlungszyklen eine im wesentlichen unveränderte Stabilität der Größen bzw. Abmessungen des Materials für das Rahmen- bzw. Trägerelement erzielbar ist, wobei der Zusatz "*" bei zwei Zyklen andeutet, daß nach einer derartigen zweifachen bzw. doppelten Wärmebehandlung keine weiteren Änderungen der Abmessungen des Materials für das Rahmen- bzw. Trägerelement zu erwarten sind, so daß ein entsprechendes form- und dimensionsstabiles Rahmen- bzw. Trägerelement zur Verfügung gestellt werden kann.

Insbesondere unter Berücksichtigung der Tatsache, daß das in Fig. 3 dargestellte Zeit-Temperatur-Diagramm ähnlich einer Temperaturführung bzw. Wärmebehandlung bei der Herstellung von Leiterplatten in nachfolgenden Löt- bzw. Reflow-Prozessen bei einer Bestückung von Leiterplatten ausgebildet ist, läßt sich aus der Darstellung gemäß Fig. 4 darüber hinaus unmittelbar ableiten, daß nach einer zweifachen Wärmebehandlung bzw. Vorbehandlung der einzusetzenden Rahmen- bzw. Trägerelemente während nachfolgender Bearbeitungsschritte bei der Herstellung von Leiterplatten nach einer Kopplung bzw. Verbindung derart wärmebehandelter Rahmen- bzw. Trägerelemente mit Leiterplattenelementen bei Einsatz entsprechend erhöhter Temperaturen keinerlei Abmessungs- bzw. Dimensionsänderungen der Rahmen- bzw. Trägerelemente und somit der gegenseitigen Anordnung einer Vielzahl von Leiterplattenelementen zu erwarten sind.

Demgemäß wird es durch Bereitstellung der form- bzw. dimensionsstabilen Rahmen- bzw. Trägerelemente möglich, mit derartigen Rahmen- bzw. Trägerelementen eine überaus große Anzahl von Leiterplattenelementen zu verbinden bzw. zu koppeln und diese gemeinsamen Be- bzw. Verarbeitungsschritten, insbesondere einer Bestückung zu unterwerfen. Unter Berücksichtigung der erhöhten Form- bzw. Dimensionsstabilität auch der Rahmen- bzw. Trägerelemente kann somit selbst bei gleichzeitigem Einsatz einer überaus großen Anzahl von Leiterplattenelementen der Ausschuß verringert werden, so daß auch hiedurch die Kosten für die Herstellung einzelner Leiterplattenelemente entsprechend reduziert werden können.

Aus dem Diagramm gemäß Fig. 5 ist ersichtlich, daß nach einer mit "01" und "02" bezeichneten, vorgenommenen ersten und zweiten Wärmebehandlung der Rahmen- bzw. Trägerelemente beispielsweise entsprechend dem in Fig. 3 dargestellten Zeit-Temperatur-Diagramm über eine Zeit von mindestens 48 Stunden eine entsprechende Form- bzw. Abmessungsstabilität der behandelten Rahmen- bzw. Trägerelemente aufrecht erhalten werden kann.

Lediglich nach einer weiteren Lagerung derartiger wärmebehandelter Rahmen- bzw. Trägerelemente über einen Zeitraum von einigen Tagen bzw. Wochen bei Umgebungsbedingungen zeigt sich, daß die durch die Wärmebehandlung erzielte Form- bzw. Abmessungsstabilität wiederum abnimmt.

Aus dem Diagramm gemäß Fig. 5 läßt sich somit ableiten, daß eine Kopplung bzw. Verbindung der wärmebehandelten Rahmen- bzw. Trägerelemente mit Leiterplattenelementen für eine weitere Be- bzw. Verarbeitung günstigerweise innerhalb weniger Tage, insbesondere innerhalb von 48 Stunden für die Beibehaltung der durch die Form- bzw. Dimensionsstabilität der behandelten Rahmen- bzw. Trägerelemente erreichbaren Vorteile vorzunehmen ist.

Falls eine unmittelbare Be- bzw. Verarbeitung nach einer Verbindung bzw. Kopplung mit Leiterplattenelementen nicht möglich bzw. nicht vorgesehen ist, kann eine Verschlechterung der Form- bzw. Dimensionsstabilität dadurch verhindert werden, daß ebenfalls innerhalb eines vergleichsweise kurzen Zeitraums nach der Wärmebehandlung und günstiger nach spätestens 48 Stunden eine luftdichte Verpackung unter Ausschluß von Feuchtigkeit und Lagerung der wärmebehandelten Rahmen- bzw. Trägerelemente vorgenommen wird, worauf beispielsweise die wärmebehandelten Rahmen- bzw. Trägerelemente vor einem weiteren Einsatz im Rahmen einer Herstellung von Leiterplatten einer auch gegebenenfalls länger dauernder, insbesondere monatelangen Lagerung zugeführt werden können.

Nach einer derartigen Lagerung von Rahmen- bzw. Trägerelementen ist wiederum zu beachten, daß innerhalb eines vergleichsweise kurzen Zeitraums von einigen Stunden nach einer Entnahme aus einer luftdichten Verpackung eine Verbindung der Rahmen- bzw. Trägerelemente mit weiter zu bearbeitenden Leiterplattenelementen erfolgt.

Ein Rahmen- bzw. Trägerelement, welches einer Temperaturbehandlung entsprechend den obigen Ausführungen unterworfen wurde, weist bei den nachfolgend genannten Abmessungen die angegebene Form- bzw. Dimensionsstabilität auf.

Bei einer Größe eines Arrays bzw. Nutzens, welche durch die Abmessungen des Rahmenelements gegeben ist, von beispielsweise 230 x 142 mm ergibt sich eine Diagonale von 270 mm. Bei einer geforderten Genauigkeit von beispielsweise ± 50 µm vor und nach nachfolgenden Bearbeitung- bzw. Behandlungsschritten nach Aufnahme einer Mehrzahl von Leiterplattenelementen, beispielsweise nach Reflow-Prozessen, wird somit eine Dimensions- bzw. Abmessungsstabilität des Rahmen- bzw. Trägerelements von ± 0,0185 % bei einer Prozeßfähigkeit von 4 Sigma benötigt.

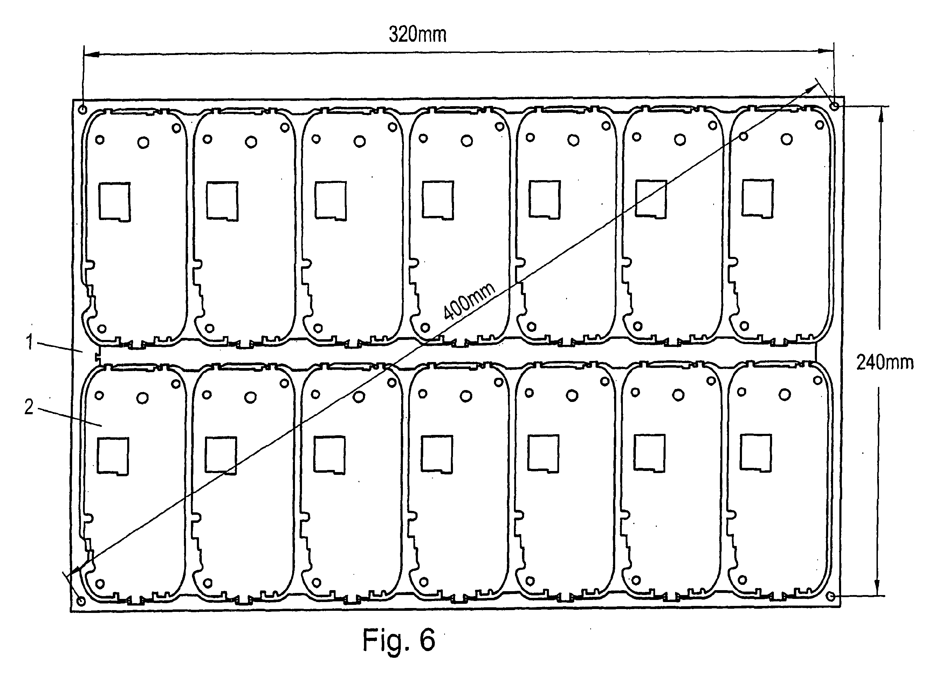

Gemäß einer abgewandelten Ausführungsform eines Rahmen- bzw. Trägerelements 1 zur Bereitstellung eines Arrays bzw. Nutzens zur Aufnahme einer Mehrzahl von schematisch angedeuteten Leiterplattenelementen 2 mit Abmessungen von 320 x 240 mm, wie dies in Fig. 6 angedeutet ist, ergibt sich eine resultierende Diagonale von 400 mm.

Bei einer bei hochpräzisen Anwendungen geforderten maximalen Abweichung von ± 30 µm vor und nach nachfolgenden Bearbeitungsschritten, beispielsweise Reflow-Prozessen nach der Aufnahme einer Mehrzahl von Leiterplattenelementen 2 ergibt sich somit eine erforderliche Abmessung- bzw. Dimensionsstabilität des Rahmen- bzw. Trägerelements 1 von 0,0075 % bei einer Prozeßfähigkeit von 4 Sigma.

## Patentansprüche

1. Verfahren zum Vorbehandeln eines Rahmen- bzw. Trägerelements (1) zum Einsatz bei der Herstellung einer Leiterplatte, wobei das Rahmen- bzw. Trägerelement (1) nach der Vorbehandlung mit wenigstens einem Leiterplattenelement (2) gekoppelt wird und wenigstens einem Bearbeitungsschritt insbesondere unter erhöhter Temperatur gemeinsam mit dem Leiterplattenelement (2), insbesondere einer Bestückung des Leiterplattenelements (2), unterworfen wird, wobei das Rahmen- bzw. Trägerelement (1) einer Wärmebehandlung bei Temperaturen zwischen 120 °C und 350 °C, insbesondere 200 °C bis 300 °C, für einen Zeitraum (t_{ges}) von 5 bis 300 Sekunden, insbesondere 10 bis 200 Sekunden unterworfen wird, **dadurch gekennzeichnet, dass** das Rahmen- bzw. Trägerelement (1) unmittelbar nach der Wärmebehandlung mit wenigstens einem Leiterplattenelement (2) verbunden bzw. gekoppelt und einer Bearbeitung des Leiterplattenelements (2) unterworfen wird oder dass das Rahmen- bzw. Trägerelement (1) nach der Wärmebehandlung vor einer Kopplung mit einem Leiterplattenelement (2) unter Feuchtigkeitsausschluss und luftdicht verpackt wird und gelagert wird.

2. Verfahren zum Vorbehandeln eines Rahmen- bzw. Trägerelements nach Anspruch 1, **dadurch gekennzeichnet, dass** das Rahmen- bzw. Trägerelement (1) einer Wärmebehandlung bei einer Temperatur von wenigstens 210 °C für einen Zeitraum (t₁₂, t₂) von 40 bis 100 Sekunden, insbesondere wenigstens 60 Sekunden unterworfen wird.

3. Verfahren zum Vorbehandeln eines Rahmen- bzw. Trägerelements nach Anspruch 1 oder 2, **dadurch gekennzeichnet, dass** das Rahmen- bzw. Trägerelement (1) einer Wärmebehandlung bei einer Temperatur (t₁₃, t₃) von wenigstens 250 °C für einen Zeitraum von wenigstens 10 Sekunden unterworfen wird.

4. Verfahren zum Vorbehandeln eines Rahmen- bzw. Trägerelements nach Anspruch 1, 2 oder 3, **dadurch gekennzeichnet, dass** das Rahmen- bzw. Trägerelement (1) einer Wärmebehandlung bei einer Temperatur von wenigstens 140 °C, insbesondere zwischen 150 °C und 180 °C, für einen Zeitraum (t₁₁, t₁) von wenigstens 100 Sekunden, insbesondere 120 bis 180 Sekunden vor einem weiteren Erwärmen auf wenigstens 210 °C unterworfen wird.

5. Verfahren zum Vorbehandeln eines Rahmen- bzw. Trägerelements nach einem der Ansprüche 1 bis 4, **dadurch gekennzeichnet, dass** das Rahmen- bzw. Trägerelement (1) nach einer Wärmebehandlung bei einer maximalen Temperatur mit einer Abkühlgeschwindigkeit von 3 °C/s bis 7 °C/s, insbesondere maximal 5 °C/s abgekühlt wird.

6. Verfahren zum Vorbehandeln eines Rahmen- bzw. Trägerelements nach einem der Ansprüche 1 bis 5, **dadurch gekennzeichnet, dass** das Rahmen- bzw. Trägerelement (1) einer mehrfachen Wärmebehandlung mit dazwischen liegender Abkühlung unterworfen wird.

7. Verfahren nach einem der Ansprüche 1 bis 6, **dadurch gekennzeichnet, dass** das Rahmen- bzw. Trägerelement (1) vor der Wärmebehandlung einem Verpressen und Aushärten unterworfen wird und/oder aus mehreren Lagen eines Ausgangsmaterials aufgebaut wird.

8. Verfahren zum Vorbehandeln eines Rahmen- bzw. Trägerelements nach einem der Ansprüche 1 bis 7, **dadurch gekennzeichnet, dass** ein vollflächiges bzw. plattenförmiges Basismaterial der Wärmebehandlung unterworfen wird und dass das Rahmen- bzw. Trägerelement (1) nach dem Abkühlen des plattenförmigen Basismaterials aus diesem ausgebildet, insbesondere geschnitten wird.

9. Verfahren zum Vorbehandeln eines Rahmen- bzw. Trägerelements nach einem der Ansprüche 1 bis 8, **dadurch gekennzeichnet, dass** das Rahmen- bzw. Trägerelement (1) nach der Wärmebehandlung vor einer Kopplung mit einem Leiterplattenelement (2) vakuumverpackt und gelagert wird.

10. Verfahren zum Vorbehandeln eines Rahmen- bzw. Trägerelements nach einem der Ansprüche 1 bis 9, **dadurch gekennzeichnet, dass** eine Verbindung bzw. Kopplung des Rahmen- bzw. Trägerelements (1) mit einem Leiterplattenelement (2) oder ein Verpacken des Rahmen- bzw. Trägerelements (1) nach einem Zeitraum von höchstens 72 Stunden, insbesondere höchstens 48 Stunden nach der Wärmebehandlung vorgenommen wird.

11. Verfahren zum Vorbehandeln eines Rahmen- bzw. Trägerelements nach einem der Ansprüche 1 bis 10, **dadurch gekennzeichnet, dass** das Rahmen- bzw. Trägerelement (1) in an sich bekannter Weise aus einem für die Herstellung eines Leiterplattenelements geeigneten Material, insbesondere einem mit Epoxidharz getränkten Glasfasermattenmaterial gebildet wird.

12. Verfahren gemäß einem der Ansprüche 1 bis 11, wobei das Rahmen- bzw. Trägerelement (1) zur Verbindung und Bearbeitung mit wenigstens einem Leiterplattenelement (2), bei der Herstellung einer Leiterplatte verwendet wird.

## Claims

1. A method for pre-treating a frame or support element (1) for use in the production of a printed circuit board, wherein the frame or support element (1) is coupled with at least one printed circuit board element (2) after pre-treating and subjected to at least one processing step, particularly at elevated temperature, together with the printed circuit board element, in particular mounting of the printed circuit board element (2), wherein the frame or support element (1) is subjected to a heat treatment at temperatures of between 120°C and 350°C, in particular 200°C to 300°C, for a period (t_{ges}) of 5 to 300 seconds, in particular 10 to 200 seconds, **characterized in that** the frame or support element (1), immediately after the heat treatment, is connected or coupled with at least one printed circuit board element (2) and subjected to processing of the printed circuit board element (2) or **in that** the frame or support element (1), after the heat treatment and prior to coupling with a printed circuit board element (2), is hermetically packaged, under the exclusion of moisture, and stored.

2. A method for pre-treating a frame or support element according to claim 1, **characterized in that** the frame or support element (1) is subjected to a heat treatment at a temperature of at least 210°C for a period (t₁₂, t₂) of 40 to 100 seconds and, in particular, at least 60 seconds.

3. A method for pre-treating a frame or support element according to claim 1 or 2, **characterized in that** the frame or support element (1) is subjected to a heat treatment at a temperature (t₁₃, t₃) of at least 250°C for a period of at least 10 seconds.

4. A method for pre-treating a frame or support element according to claim 1, 2 or 3, **characterized in that** the frame or support element (1) is subjected to a heat treatment at a temperature of at least 140°C and, in particular, between 150°C and 180°C, for a period (t₁₁, t₁) of at least 100 seconds and, in particular, 120 to 180 seconds, prior to further heating to at least 210°C.

5. A method for pre-treating a frame or support element according to any one of claims 1 to 4, **characterized in that** the frame or support element (1), after a heat treatment at a maximum temperature, is cooled at a cooling rate of 3°C/s to 7°C/s and, in particular, 5°C/s at the most.

6. A method for pre-treating a frame or support element according to any one of claims 1 to 5, **characterized in that** the frame or support element (1) is subjected to a multiple heat treatment with intermediate cooling.

7. A method for pre-treating a frame or support element according to any one of claims 1 to 6, **characterized in that** the frame or support element (1), prior to the heat-treatment, is subjected to pressing and curing and/or assembled of several layers of a starting material.

8. A method for pre-treating a frame or support element according to any one of claims 1 to 7, **characterized in that** a full-surface or plate-shaped base material is subjected to the heat treatment, and that the frame or support element (1), after cooling of the plate-shaped base material, is formed, particularly cut, out of the same.

9. A method for pre-treating a frame or support element according to any one of claims 1 to 8, **characterized in that** the frame or support element (1), after the heat treatment and prior to coupling with a printed circuit board element (2) is vacuum-packed and stored.

10. A method for pre-treating a frame or support element according to any of the claims 1 to 9, **characterized in that** a connection or coupling of the frame or support element (1) with a printed circuit board element (2), or packaging of the frame or support element (1), is effected after a maximum period of 72 hours and, in particular, 48 hours following the heat treatment.

11. A method for pre-treating a frame or support element according to any one of claims 1 to 10, **characterized in that** the frame or support element (1), in a manner known per se, is formed of a material suitable for the production of a printed circuit board element, in particular a glass-fiber mat material impregnated with an epoxy resin.

12. A method according to any one of claims 1 to 11, wherein the frame or support element (1) is used in the production of a printed circuit board for connection and processing with at least one printed circuit board element (2).

## Revendications

1. Procédé servant au prétraitement d'un élément de cadre ou de support (1) destiné à être utilisé lors de la fabrication d'une carte de circuits imprimés, sachant que l'élément de cadre ou de support (1) est couplé après le traitement préalable à au moins un élément de carte de circuits imprimés (2) et est soumis à au moins une étape de traitement en particulier à une température élevée conjointement avec l'élément de carte de circuits imprimés (2), en particulier avec un composant de l'élément de carte de circuits imprimés (2), sachant que l'élément de cadre ou de support (1) est soumis à un traitement thermique à des températures comprises entre 120°C et 350 °C, en particulier entre 200°C et 300°C, pour une période (t_{ges}) allant de 5 à 300 secondes, en particulier allant de 10 à 200 secondes, **caractérisé en ce que** l'élément de cadre ou de support (1) est relié ou couplé directement après le traitement thermique à au moins un élément de carte de circuits imprimés (2) et est soumis à un traitement de l'élément de la carte de circuits imprimés (2), ou **en ce que** l'élément de cadre ou de support (1) est emballé et logé de manière hermétique à l'air et sans humidité après le traitement thermique avant un couplage à un élément de carte de circuits imprimés (2).

2. Procédé servant au prétraitement d'un élément de cadre ou de support selon la revendication 1, **caractérisé en ce que** l'élément de cadre ou de support (1) est soumis à un traitement thermique à une température d'au moins 210°C pour une période (t₁₂, t₂) allant de 40 à 100 secondes, en particulier pour une période d'au moins 60 secondes.

3. Procédé servant au prétraitement d'un élément de cadre ou de support selon la revendication 1 ou 2, **caractérisé en ce que** l'élément de cadre ou de support (1) est soumis à un traitement thermique à une température (t₁₃, t₃) d'au moins 250°C pour une période d'au moins 10 secondes.

4. Procédé servant au prétraitement d'un élément de cadre ou de support selon la revendication 1, 2 ou 3, **caractérisé en ce que** l'élément de cadre ou de support (1) est soumis à un traitement thermique à une température d'au moins 140°C, en particulier à une température comprise entre 150°C et 180°C, pour une période (t₁₁, t₁) d'au moins 100 secondes, en particulier pour une période allant de 120 à 180 secondes, avec un autre réchauffement à au moins 210°C.

5. Procédé servant au prétraitement d'un élément de cadre ou de support selon l'une quelconque des revendications 1 à 4, **caractérisé en ce que** l'élément de cadre ou de support (1) est refroidi après un traitement thermique à une température maximale avec une vitesse de refroidissement allant de 3°C°/s à 7°C/s, en particulier à une vitesse de refroidissement de maximum 5°C/s.

6. Procédé servant au prétraitement d'un élément de cadre ou de support selon l'une quelconque des revendications 1 à 5, **caractérisé en ce que** l'élément de cadre ou de support (1) est soumis à un traitement thermique répété avec entre-temps un refroidissement.

7. Procédé selon l'une quelconque des revendications 1 à 6, **caractérisé en ce que** l'élément de cadre ou de support (1) est soumis avant le traitement thermique à une compression et à un durcissement, et/ou est constitué de plusieurs couches d'un matériau de départ.

8. Procédé servant au prétraitement d'un élément de cadre ou de support selon l'une quelconque des revendications 1 à 7, **caractérisé en ce qu'**un matériau de base de surface pleine ou en forme de plaque est soumis au traitement thermique, et **en ce que** l'élément de cadre ou de support (1) est réalisé, en particulier découpé, à partir du matériau de base en forme de plaque après le refroidissement de ce dernier.

9. Procédé servant au prétraitement d'un élément de cadre ou de support selon l'une quelconque des revendications 1 à 8, **caractérisé en ce que** l'élément de cadre ou de support (1) est emballé sous vide et logé après le traitement thermique avant un couplage à un élément de carte de circuits imprimés (2).

10. Procédé servant au prétraitement d'un élément de cadre ou de support selon l'une quelconque des revendications 1 à 9, **caractérisé en ce qu'**une liaison ou un couplage de l'élément de cadre ou de support (1) à un élément de carte de circuits imprimés (2) ou un emballage de l'élément de cadre ou de support (1) sont effectués après le traitement thermique après une période de maximum 72 heures, en particulier de maximum 48 heures.

11. Procédé servant au prétraitement d'un élément de cadre ou de support selon l'une quelconque des revendications 1 à 10, **caractérisé en ce que** l'élément de cadre ou de support (1) est formé d'une manière connue en soi à partir d'un matériau approprié pour la fabrication d'un élément de carte de circuits imprimés, en particulier à partir d'un matériau de mat de fibres de verre imprégné de résine époxy.

12. Procédé selon l'une quelconque des revendications 1 à 11, sachant que l'élément de cadre ou de support (1) est utilisé lors de la fabrication d'une carte de circuits imprimés aux fins de l'assemblage à au moins un élément de carte de circuits imprimés (2) et du traitement de ce dernier.
